(19) Europäisches Patentamt
European Patent Office
Office européen des brevets

(11) **EP 4 246 158 B1**

(12) **EUROPEAN PATENT SPECIFICATION**

(45) Date of publication and mention
of the grant of the patent:
**04.09.2024 Bulletin 2024/36**

(21) Application number: **22162127.9**

(22) Date of filing: **15.03.2022**

(51) International Patent Classification (IPC):
***G01R 31/36*** (2020.01)   ***G01R 31/385*** (2019.01)

(52) Cooperative Patent Classification (CPC):
**G01R 31/386; G01R 31/3647; G01R 31/3865;**
**Y02T 10/70**

(54) **A METHOD FOR ESTIMATING BATTERY SUPPLY VOLTAGE**

VERFAHREN ZUR SCHÄTZUNG DER BATTERIEVERSORGUNGSSPANNUNG

PROCÉDÉ D'ESTIMATION DE TENSION D'ALIMENTATION DE BATTERIE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**20.09.2023 Bulletin 2023/38**

(73) Proprietors:
• **Ningbo Geely Automobile Research**
**& Development Co. Ltd.**
**Hangzhou Bay New District**
**Ningbo 315336 (CN)**
• **Zhejiang Geely Holding Group Co., Ltd.**
**Hangzhou, Zhejiang 310051 (CN)**

(72) Inventors:
• **SORANI, Heza**
**421 51 VÄSTRA FRÖLUNDA (SE)**

• **RUDERVALL, Eric**
**431 31 MÖLNDAL (SE)**
• **FRANZÉN, Linus**
**511 68 HYSSNA (SE)**
• **RYDGÅRD, Andreas**
**416 70 GÖTEBORG (SE)**

(74) Representative: **Zacco Sweden AB**
**P.O. Box 5581**
**Löjtnantsgatan 21**
**114 85 Stockholm (SE)**

(56) References cited:
**DE-A1- 102016 121 630    US-A1- 2002 113 593**
**US-A1- 2011 172 939    US-A1- 2020 331 359**
**US-B1- 6 526 361**

**Description**

TECHNICAL FIELD

The present disclosure relates to method for estimating a minimum continuous and transient supply voltage of a battery. The disclosure further relates to a method for selecting an appropriate battery type and/or size for powering a vehicle electrical circuit, a method for manufacturing a vehicle, and a computer system comprising a processor configured for estimating a minimum continuous and transient supply voltage of a battery.

The methods and computer system according to the disclosure can be used and implemented in virtually all types of vehicles having one or more electrical loads powered by a battery. However, the methods and computer system according to the disclosure may be deemed particularly useful in vehicle electrical systems that are sensitive to low battery supply voltage due to for example an operating situation involving maximal continuous and/or transient power consumption.

Moreover, even if the methods and computer system according to the disclosure will be described primarily in relation to a car, the methods and computer system is not restricted to this particular vehicle, but may as well be installed or implemented in another type of vehicle, such as a truck, a bus, a rail vehicle, a flying vehicle, a marine vessel, an off-road vehicle, an agriculture vehicle, a working, a forest vehicle, a motorcycle or the like.

BACKGROUND

In the field of power supply systems for vehicles, the number of electrical loads are increasing and they are also partly having a more dynamic behaviour in terms of their current profile. This is particularly relevant, but not restricted to, vehicles having increased autonomous driving capability, because electrical loads such as electrical braking and electrical steering have a highly dynamic current discharge profiles over time.

At the same time, the supply voltage of an electrical battery generally decreases with increased discharge current, thereby causing problems such as potentially reduced operating reliability of certain electrical loads due to low supply voltage level from the battery.

A common issue during the design process of vehicle electrical circuit is thus to select a suitable battery that can guarantee stable voltage quality and robustness for all load scenarios. However, since the internal resistance of the battery varies with respect to its chemistry/technology and the load scenarios, it is difficult to make a reliable estimate of the final voltage level at certain load.

Consequently, in view of the difficulty of selecting a suitable battery type and charge level, battery warranty is a major cost driver in the automotive industry, as the batteries are cycled hard in different ways to support the 12V electrical system; regenerative charging; quiescent current draining; transient current loads etc.

In addition, designing a battery for the automotive industry is complex due to the vast temperature range and the various load scenarios that occur during the lifetime of the vehicle. Prior art document US2002/113593 predicts whether a battery will be able to perform a certain function, eg cranking. An SoC-temperature-battery voltage drop curve is constructed based on historical cranking/temperature events and used to predict whether a future cranking event will drop the battery voltage too much, but not by producing continuous/ transient related coefficients expressing a ratio of internal battery resistance to current value. US2011/172939 recognizes that a step change in current can affect the value of the internal battery resistance and suggests correcting it, again without calculating a continuous current Rint/I coefficient and a transient current Rint/I coefficient. Further art is known from DE102016/121630, US2020/331359, and US6526361.

There is thus a demand for an improved method for more reliably and faster being able to determine the method for estimating a minimum supply voltage of a battery.

There is also a demand for a method for selecting an appropriate battery for powering a vehicle electrical circuit based on said minimum supply voltage, a method for manufacturing a vehicle having said battery, and a computer system comprising a processor configured for estimating a minimum supply voltage of a battery.

SUMMARY

An object of the present disclosure is to provide a method for estimating a minimum supply voltage of a battery, as well as method for selecting an appropriate battery for powering a vehicle electrical circuit based on said minimum supply voltage, a method for manufacturing a vehicle having said battery, and a computer system comprising a processor configured for estimating said minimum supply voltage of the battery, where the previously mentioned problems are avoided. This object is at least partly achieved by the features of the independent claims.

According to an aspect of the present disclosure, there is provided a method for estimating a minimum continuous and transient supply voltage of a battery when the battery is connected and supplying electrical power to a vehicle electrical circuit. The method comprising: performing a first electrical load test of the battery by executing a first battery discharge sequence including a continuous discharge current and at least one transient discharge pulse, while registering parameters characterising a discharge current profile and discharge voltage profile of the battery during the first battery discharge sequence; performing a second electrical load test of the battery by executing a second battery discharge sequence including a continuous discharge current and at least one transient discharge pulse, while registering parameters characterising a discharge current profile and discharge voltage profile of the battery during the second battery discharge sequence; determining a value of a continuous battery coefficient reflecting a ratio of battery internal resistance to continuous discharge current based on said registered parameters; determining a value of a transient battery coefficient reflecting a ratio of battery internal resistance to transient discharge current based on said registered parameters; obtaining information about a maximum expected continuous load current and maximum expected transient load current of the vehicle electrical circuit; calculating an estimate of the minimum continuous supply voltage from the battery using said continuous battery coefficient and said maximum expected continuous load current, and calculating a minimum transient supply voltage from the battery using said transient battery coefficient and said maximum expected transient load current, when the battery is connected and supplying electrical power to said vehicle electrical circuit.

In this way, an improved method for more reliable and faster being able to accurately estimating a minimum supply voltage of a battery is provided. Specifically, by performing at least two real current discharge tests on the battery, i.e. two experimental test, each test having an individual current profile with respect to continuous and transient load behaviour, estimation of the minimum continuous and transient supply voltage of the battery may be accomplished using for example linear or non-linear interpolation. In addition, by using a continuous battery coefficient and a transient battery coefficient, which correspond to battery individual parameters, re-evaluation of an estimated minimum supply voltage of a battery may be more easily performed in case one or more electrical loads are modified, removed, replaced or added to the vehicle electric circuit.

Further advantages are achieved by implementing one or several of the features of the dependent claims.

For example, in some example embodiments, the step of registering parameters characterising the discharge current profile and discharge voltage profile of the battery during the first battery discharge sequence involves registering a first battery open-circuit voltage, registering a first battery continuous discharge voltage and a first battery continuous discharge current of said continuous discharge current, and registering a first battery transient discharge voltage and a first battery transient discharge current of said transient discharge pulse; and the step of registering parameters characterising the discharge current profile and discharge voltage profile of the battery during the second battery discharge sequence involves registering a second battery open-circuit voltage, registering a second battery continuous discharge voltage and a second battery continuous discharge current of said continuous discharge current, and registering a second battery transient discharge voltage and a second battery transient discharge current of said transient discharge pulse. By detecting and registering both continuous and transients currents, a more reliable and accurate charge current profile and discharge voltage profile of the battery is obtained, thereby enabling a more reliable and accurate estimation of the battery minimum continuous and transient supply voltage.

In some example embodiments, that may be combined with any one or more of the above-described embodiments, the value of the continuous battery coefficient is determined based on the registered first and second battery open-circuit voltage, the registered first and second battery continuous discharge voltage, and the registered first and second battery continuous discharge current. This represents one approach for obtaining an accurate discharge current and discharge voltage profile of the battery.

In some example embodiments, that may be combined with any one or more of the above-described embodiments, the value of a transient battery coefficient is determined based on the registered first and second battery continuous discharge voltage, the registered first and second battery transient discharge voltage, and the registered first and second battery transient discharge current. This represents one approach for obtaining an accurate discharge current and discharge voltage profile of the battery.

In some example embodiments, that may be combined with any one or more of the above-described embodiments, each of the first and second electrical load test of the battery is performed by first ensuring connection of the battery to an electrical load test circuit. Use of a load test circuit enables provision of a pre-determined current and voltage discharge profiles in a cost-efficient manner.

In some example embodiments, that may be combined with any one or more of the above-described embodiments, the electrical load test circuit includes a programmable DC-load that is programmed to execute said first and second battery discharge sequences. Use of a programmable load test circuit enables provision of a pre-determined current and voltage discharge profiles in a cost-efficient manner.

In some example embodiments, that may be combined with any one or more of the above-described embodiments, the programmable DC-load further is programmed to register said parameters characterising the discharge current profile and discharge voltage profile of the battery during said first and second battery discharge sequences, and to store said parameters with a time stamp. Thereby, no additional electrical equipment for registering said parameters is required.

In some example embodiments, that may be combined with any one or more of the above-described embodiments, the maximum expected continuous load current of the vehicle electrical circuit is selected to be located within boundaries of the registered first and second battery continuous discharge current, and wherein the maximum expected transient load current of the vehicle electrical circuit is selected to be located within boundaries of the registered first and second battery transient discharge current. Thereby, the likelihood increases that the estimated battery minimum continuous and transient supply voltage level is correct.

In some example embodiments, that may be combined with any one or more of the above-described embodiments, the method further comprises, for each of a plurality of different battery state of charge levels and/or for each of a plurality of different battery temperature levels, calculating an estimate of the minimum continuous supply voltage from the battery using said continuous battery coefficient and said maximum expected continuous load current, and calculating a minimum transient supply voltage from the battery using said transient battery coefficient and said maximum expected transient load current, when the battery is connected and supplying electrical power to said vehicle electrical circuit. By taking also battery SoC and battery operating temperature into account, the estimated battery minimum continuous and transient supply voltage level will be more accurate over a wider range of battery operating conditions.

In some example embodiments, that may be combined with any one or more of the above-described embodiments, the electrical load test circuit is configured to cause, during said first battery discharge sequence, a first battery transient discharge current that is about 10-100% larger, specifically about 25-75% larger, and more specifically about 40-60% larger, than the first battery continuous discharge current; and/or the electrical load test circuit is configured to cause, during said second battery discharge sequence, a second battery transient discharge current that is about 70-200% larger, specifically about 80-160% larger, and more specifically about 90-120% larger, than the second battery continuous discharge current. By having different levels of relative transient discharge pulses in the first and second battery discharge sequences, the estimated battery minimum transient supply voltage can be more accurately determined over a broader range of possible transient discharge pulses.

In some example embodiments, that may be combined with any one or more of the above-described embodiments, a magnitude of the first continuous discharge current is at least 25% larger, specifically at least 50% larger, or at least 50A larger, specifically at least 100A larger, than the magnitude of the second continuous discharge current. By having different levels of relative continuous discharge current in the first and second battery discharge sequences, the estimated battery minimum continuous supply voltage can be more accurately determined over a broader range of possible continuous discharge current.

In some example embodiments, that may be combined with any one or more of the above-described embodiments, a difference in magnitude between the second battery transient discharge current and the second battery continuous discharge current is at least 10% larger, specifically at least 25% larger, or at least 10A larger, specifically at least 25A larger, than difference in magnitude between the first battery transient discharge current and the first battery continuous discharge current. Thereby, a more accurate and reliable minimum battery supply voltage may be determined.

In some example embodiments, that may be combined with any one or more of the above-described embodiments, a length of the continuous discharge current of the first and/or second battery discharge sequence is at least 10 seconds, specifically at least 30 seconds, and more specifically at least 60 seconds, and wherein a length of the transient discharge current of the first and/or second battery discharge sequence is less than 5 seconds, specifically less than 3 seconds, and more specifically in the range of 0.1 - 2.0 ms. This ensures that the alleged transient current pulse is, and behaves like, a relative short current pulse.

In some example embodiments, that may be combined with any one or more of the above-described embodiments, the step of determining a value of the continuous battery coefficient and a value of the transient battery coefficient is performed by means of a computer system. This provides a cost-efficient, reliable and accurate system.

In some example embodiments, that may be combined with any one or more of the above-described embodiments, the step of obtaining information about a maximum expected continuous load current and maximum expected transient load current of the vehicle electrical circuit is performed by means of a computer system. This provides a cost-efficient, reliable and accurate system.

In some example embodiments, that may be combined with any one or more of the above-described embodiments, the step of calculating an estimate of the minimum continuous supply voltage from the battery and calculating a minimum transient supply voltage from the battery, is performed by means of a computer system. This provides a cost-efficient, reliable and accurate system.

In some example embodiments, that may be combined with any one or more of the above-described embodiments, the value of the continuous battery coefficient is determined based on following equation:

$$Battery\ coefficient_{Con} = \frac{|\Delta R_{Continuous}|}{|\Delta I_{Continuous}|} = \frac{|R_1 - R_3|}{|I_{Con\_1} - I_{Con\_2}|} \quad [{}^{\Omega}/_{A}]$$

wherein

$$R_1 = \frac{U_{OCV1} - U_{Con\_1}}{I_{Con\_1}}$$

$$R_3 = \frac{U_{OCV2} - U_{Con\_2}}{I_{Con\_2}}$$

$U_{OCV1}$ = the registered first battery open-circuit voltage,
$U_{OCV2}$ = the registered second battery open-circuit voltage
$U_{con\_1}$ = the registered first battery continuous discharge voltage,
$U_{con\_2}$ = the registered second battery continuous discharge voltage
$I_{con\_1}$ = the registered first battery continuous discharge current
$I_{con\_2}$ = the registered second battery continuous discharge current.

In some example embodiments, that may be combined with any one or more of the above-described embodiments, the value of the transient battery coefficient is determined based on following equation:

$$Battery\ coefficient_{Trans} = \frac{|\Delta R_{Transient}|}{|\Delta I_{Transient}|} = \frac{|R_2 - R_4|}{|I_{Trans\_1} - I_{Trans\_2}|} \quad [^\Omega/_A]$$

wherein

$$R_2 = \frac{U_{Con\_1} - U_{Trans\_1}}{I_{Trans\_1}}$$

$$R_4 = \frac{U_{Con\_2} - U_{Trans\_2}}{I_{Trans\_2}}$$

$U_{con\_1}$ = the registered first battery continuous discharge voltage,
$U_{con\_2}$ = the registered second battery continuous discharge voltage
$U_{trans\_1}$ = first battery transient discharge voltage
$U_{trans\_2}$ = second battery transient discharge voltage
$I_{trans\_1}$ = the registered first battery transient discharge current,
$I_{trans\_2}$ = the registered second battery transient discharge current.

In some example embodiments, that may be combined with any one or more of the above-described embodiments, the step of calculating an estimate of the minimum continuous supply voltage from the battery using said continuous battery coefficient and said maximum expected continuous load current, and calculating a minimum transient supply voltage from the battery using said transient battery coefficient and said maximum expected transient load current, are determined based on following equations:

$$U_{\min\_con} = U_{OCV1} - \left(R_1 - \left(Battery\ coef_{Con} \cdot |I_{con\_new} - I_{con\_1}|\right)\right) \cdot I_{con\_new}$$

$$U_{\min\_trans} = U_{\min\_con} - \left(R_2 - \left(Battery\ coef_{Trans} \cdot |I_{trans\_new} - I_{trans\_1}|\right)\right) \cdot I_{trans\_new}$$

wherein

$U_{OCV1}$ = the registered first battery open-circuit voltage,

$$R_1 = \frac{U_{OCV1} - U_{Con\_1}}{I_{Con\_1}}$$

$$R_2 = \frac{U_{Con\_1} - U_{Trans\_1}}{I_{Trans\_1}}$$

$U_{OCV1}$ = the registered first battery open-circuit voltage,
$U_{con\_1}$ = the registered first battery continuous discharge voltage,
$I_{con\_1}$ = the registered first battery continuous discharge current
$U_{trans\_1}$ = first battery transient discharge voltage
$I_{trans\_1}$ = the registered first battery transient discharge current,
Battery $coef_{con}$ = the continuous battery coefficient
Battery $coef_{trans}$ = the transient battery coefficient
$I_{con\_new}$ = the maximum expected continuous load current,
$I_{trans\_new}$ = the maximum expected transient load current.

The disclosure also relates to a method for selecting an appropriate battery type and/or size for powering a vehicle electrical circuit. The method comprises: determining a maximum expected continuous load current and maximum expected transient load current of the vehicle electrical circuit; identifying a battery that has a minimum continuous supply voltage and a minimum transient supply voltage, when the battery is connected and supplying electrical power to said vehicle electrical circuit, that are larger than said maximum expected continuous load current and maximum expected transient load current of the vehicle electrical circuit, using any example embodiment of the method described above.

The disclosure also relates to a method for manufacturing a vehicle comprising installing a battery in the vehicle and connecting the battery to a vehicle electrical circuit, wherein the battery has been selected using any example embodiment of the method described above.

The disclosure also relates to a computer system comprising a processor configured for estimating a minimum continuous and transient supply voltage of a battery when the battery is connected and supplying electrical power to a vehicle electrical circuit. The computer system being configured for: receiving battery parameters characterising a discharge current profile and discharge voltage profile of the battery registered while performing a first electrical load test of the battery by executing a first battery discharge sequence including a continuous discharge current and at least one transient discharge pulse; receiving battery parameters characterising a discharge current profile and discharge voltage profile of the battery registered while performing a second electrical load test of the battery by executing a second battery discharge sequence including a continuous discharge current and at least one transient discharge pulse; determining a value of a continuous battery coefficient reflecting a ratio of battery internal resistance to continuous discharge current based on said received parameters; determining a value of a transient battery coefficient reflecting a ratio of battery internal resistance to transient discharge current based on said received parameters; obtaining information about a maximum expected continuous load current and maximum expected transient load current of the vehicle electrical circuit; calculating an estimate of the minimum continuous supply voltage from the battery using said continuous battery coefficient and said maximum expected continuous load current, and calculating a minimum transient supply voltage from the battery using said transient battery coefficient and said maximum expected transient load current, when the battery is connected and supplying electrical power to said vehicle electrical circuit.

Further features and advantages of the invention will become apparent when studying the appended claims and the following description. The skilled person in the art realizes that different features of the present disclosure may be combined to create embodiments other than those explicitly described hereinabove and below, without departing from the scope of the present disclosure.

BRIEF DESCRIPTION OF DRAWINGS

The method for estimating a minimum continuous and transient supply voltage of a battery according to the disclosure will be described in detail in the following, with reference to the attached drawings, in which

Fig. 1-2            show schematically two example embodiments of a vehicle electrical circuit having a battery,

Fig. 3              shows the battery connected to a DC test circuit,

Fig. 4, 9 and 10    show schematically various example embodiments of the methods according to the disclosure,

Fig. 5A-5B, 6A-6B       show current and voltage profiles of the first and second battery test sequences, and

Fig. 7-8                show schematically minimum battery supply voltage as a function of continuous and transient current, respectively, as well as the influence of battery SoC and battery operating temperature.

DESCRIPTION OF EXAMPLE EMBODIMENTS

Various aspects of the disclosure will hereinafter be described in conjunction with the appended drawings to illustrate and not to limit the disclosure, wherein like designations denote like elements, and variations of the described aspects are not restricted to the specifically shown embodiments, but are applicable on other variations of the disclosure.

Those skilled in the art will appreciate that the steps, services and functions explained herein may be implemented using individual hardware circuitry, using software functioning in conjunction with a programmed microprocessor or general purpose computer, using one or more Application Specific Integrated Circuits (ASICs) and/or using one or more Digital Signal Processors (DSPs). It will also be appreciated that when the present disclosure is described in terms of a method, it may also be embodied in one or more processors and one or more memories coupled to the one or more processors, wherein the one or more memories store one or more programs that perform the steps, services and functions disclosed herein when executed by the one or more processors.

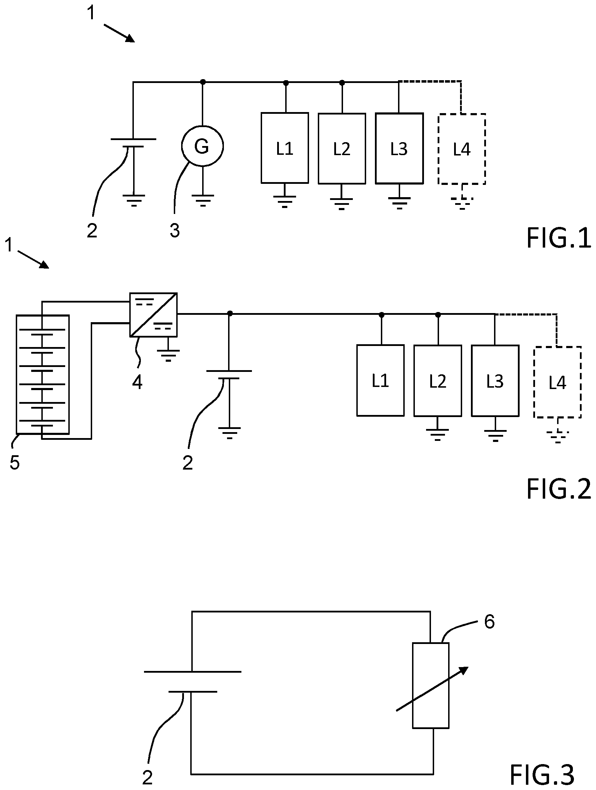

Figure 1 schematically shows an example embodiment of vehicle electrical circuit 1 comprising a battery 2 operably connected to a set of electrical loads L1, L2, L3 via a set of conducting leads.

In the example embodiment of figure 1, the vehicle electrical circuit 1 further includes an alternator 3 operably connected to an engine, such as a combustion engine, for providing stable and reliable power supply to the vehicle electrical circuit 1, and for charging the battery.

Alternatively, in the example embodiment of figure 2, the vehicle electrical circuit 1 further includes a high-voltage battery 5 connected to low-voltage battery 2 via a DC/DC converter.

According to still further example embodiments (not showed), the vehicle electrical circuit 1 may include both an alternator and a high-voltage battery 5 connected to low-voltage battery 2 via a DC/DC converter.

In some example embodiments, the battery is a low-voltage battery, having for example a nominal voltage level of 12V, 24V, 48V, or the like. The voltage is level is generally below 60V.

The battery 2 may for example be a Li-Ion type battery, a Lead-Acid type battery, solid state battery, or the like.

The electrical loads may be any type of electrical loads normally existing in a vehicle, wherein some of the larger electrical loads are for example air conditioning compressor, starter motor, electric braking system, electric steering system, vehicle electronic stabilisation program, vehicle seat heating, vehicle lighting, etc. However, also the increasingly powerful vehicle master electronic control unit(s) (ECU), or other type of electronic control units, as well as data communication buses may represent electrical loads that must be adequately powered by the battery for functioning.

In particular the ECU's, but also other electrical loads of the vehicle electric circuit, require stable and reliable power supply voltage level within pre-defined voltage limits for ensuring reliable operation of said electrical loads. However, with ever-increasing electrification of the vehicles, the electrical loads are increasing in numbers and also in their transient behavior.

It is well known that batteries provide reduced output voltage with increased discharge current. This behavior is caused by increased battery internal resistance with increased discharge current.

Consequently, for example an electric braking system and/or an electric steering system may require large sudden power supply in case of vehicle evasive maneuver or the like, thereby resulting in sudden battery supply voltage drop that potentially may compromise the reliable operation of all electrical loads of the vehicle.

It is desirable that the vehicle functions properly and safely also when the battery 2 is the sole power supply source. Such a situation may for example occur when any of the alternator 3, DC/DC converter 4 and/or high-voltage battery 5 for some reason stop functioning or delivering electrical power as planned.

Consequently, vehicle designers and manufacturers must carefully select and install a low-voltage battery 2 in the vehicle that alone ensures adequate battery supply voltage level at all reasonably possible driving situation.

Many different aspects influence the maximal battery supply voltage level as a function of discharge current, such as for example battery chemistry and battery nominal capacity (C-rating, Ampere Hour). However, battery State of Charge, battery health and battery temperature are also relevant parameters influencing the maximal battery supply voltage level.

For being able to select and install a suitable battery for a specific vehicle electric circuit, information about the estimated maximal the discharge current is required. The present disclosure proposes to take into account the estimated maximal the discharge current at both a continuous load situation and a transient load situation, for increasing the likelihood that the battery supply voltage level is always sufficiently high.

Both the estimated maximal continuous discharge current and the estimated maximal transient discharge current may be determined based on nominal discharge current data given in the specifications of each individual electrical load of the vehicle electric system, while taking into account all realistic and feasible combinations of loads.

In other words, when determining the estimated maximal continuous discharge current and the estimated maximal transient discharge current occurring during for example a sudden vehicle evasive maneuver, the total continuous discharge current and total transient discharge current of all electrical loads that are simultaneously operating at such an driving situation, as derived from the nominal current loads of each individual load given in their respective specification data sheet, may be summed up to give an estimated total maximal continuous discharge current and estimated total maximal transient discharge of the vehicle electric circuit.

This approach enables a user and/or a computer system to relatively simple and straightforward determine the estimated maximal continuous discharge current and the estimated maximal transient discharge current in case one or more electrical loads are modified, removed, replaced or added to the vehicle electric circuit, such as schematically illustrated added new electrical load L4 in figures 1 and 2.

The current method for estimating a minimum continuous and transient supply voltage of a battery when the battery is connected and supplying electrical power to a vehicle electrical circuit, is based on real load tests, i.e. experimental test, being conducted on the battery, to determine how the battery's supply voltage and supply current behaves in certain load situations.

In the present application, the load profiles used for the battery tests may for example be constant current load tests, i.e. experimental test specifically configured for detecting battery output voltage over time when supplying electrical power from the battery to a test circuit having one or more loads that results in a constant pre-determined discharge current profile.

Such an electrical load test circuit may for example be provided in form of a programmable DC electric load tester.

Figure 3 schematically illustrates an example setup suitable for performing such experimental tests, wherein a battery 2 is simply operably connected to a DC electric load tester 6, in particular a programmable DC constant current electric load tester.

Such DC load tester may thus be programmed for executing a pre-determined battery discharge sequence specially configured for giving insight in the battery operating behaviour, in particular battery supply voltage level, when faced with for example a high, medium or low continuous discharge current, and/or when faced with for example a high, medium or low transient discharge current.

The present disclosure proposes performing at least two experimental current discharge tests on the battery, wherein each test has an individual current profile with respect to continuous and transient load behaviour. For example a first test may involve programming the DC load tester to execute a first battery discharge sequence having relatively high DC continuous discharge current that is periodically or intermittently interrupted with a relatively low transient current pulse, and a second test may involve programming the DC load tester to execute a second battery discharge sequence having relatively low DC continuous discharge current that is periodically or intermittently interrupted with a relatively high transient current pulse.

Such programmed discharge currents of DC load tester will quickly and cost-efficiently provide insight in the battery continuous and transient output voltage at two discrete operating points. Furthermore, the continuous current discharge level of the first and second battery discharge sequences are preferably selected to encompass the estimated continuous current discharge level of the vehicle electric circuit, such that a reliable and accurate estimation of the minimum continuous supply voltage of the battery when operably connected to the vehicle electric circuit may be estimated using for example linear or non-linear interpolation of the experimental data sets. Similarly, the transient current discharge level of the first and second battery discharge sequences are preferably selected to encompass the estimated transient current discharge level of the vehicle electric circuit, such that a reliable and accurate estimation of the minimum transient supply voltage of the battery when operably connected to the vehicle electric circuit may be estimated.

In this way, an improved method for more reliable and faster being able to accurately estimating a minimum supply voltage of a battery is provided.

In addition, by calculating a continuous battery coefficient and a transient battery coefficient, which correspond to two battery parameters, re-evaluation of an estimated minimum supply voltage of a battery may be more easily performed in case one or more electrical loads are modified, removed, replaced or added to the vehicle electric circuit.

The continuous battery coefficient and a transient battery coefficients are for example determined based on the at least two experimental battery tests described above. Each of the continuous battery coefficient and a transient battery coefficients correspond to a battery internal resistance per current, i.e. resistance/current $[\Omega/A]$, and these coefficients may be used as characterization parameters of the battery for enabling quick and straightforward prediction of a final voltage level of any load within the test spectrum of the first and second test sequences when using this specific battery.

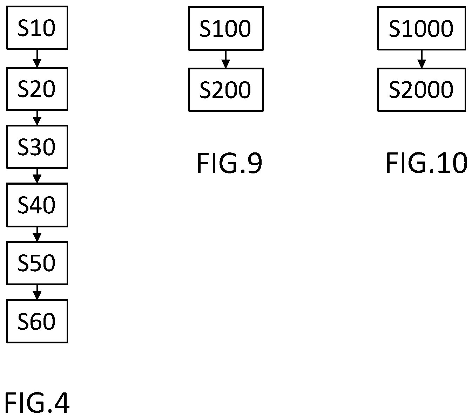

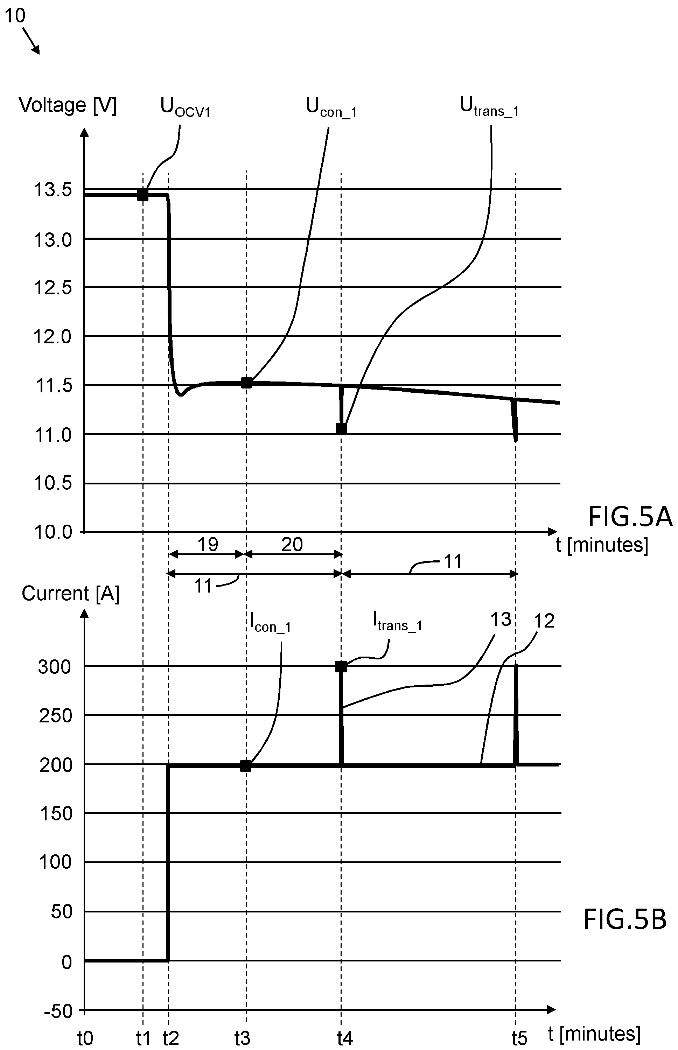

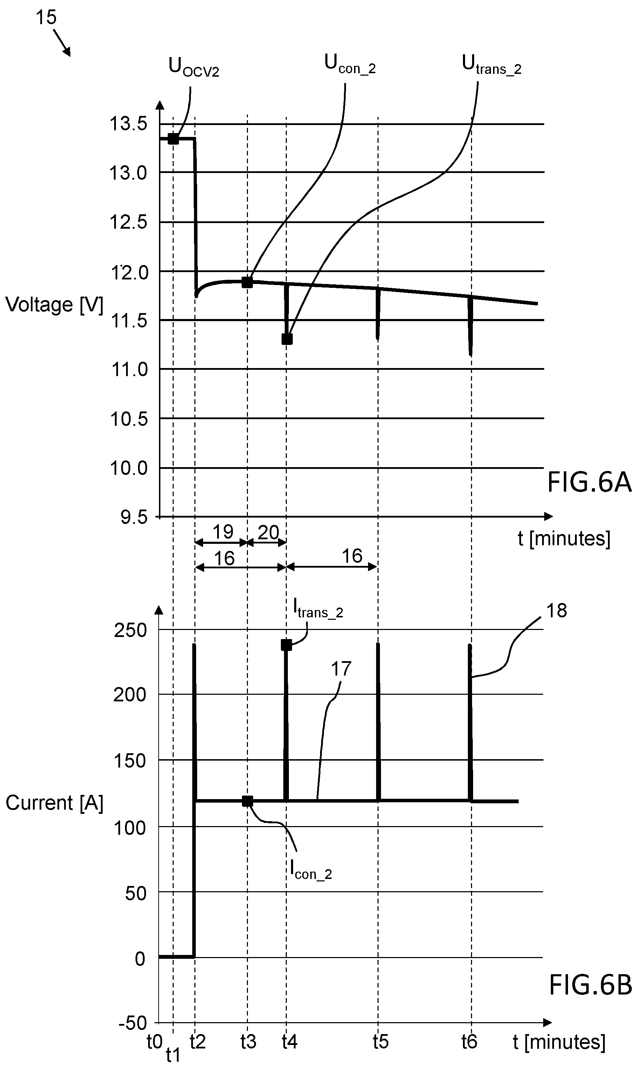

An example embodiment of the method for estimating a minimum continuous and transient supply voltage of a battery when the battery is connected and supplying electrical power to a vehicle electrical circuit, according to the disclosure, will be described below with reference to figures 4, 5A-5B and 6A-6B. Figure 4 schematically shows the basic steps of the method for estimating a minimum continuous and transient supply voltage of a battery, figures 5A-5B shows experimental test data from derived from a first battery discharge sequence, and figures 6A-6B shows experimental test data from derived from a second battery discharge sequence.

In particular, with respect to figure 4, the method comprises a first step S10 of performing a first electrical load test of the battery 2 by executing a first battery discharge sequence 10 including a time period 11 of continuous discharge current 12 and at least one transient discharge pulse 13, while registering parameters characterising a discharge current profile (figure 5B) and discharge voltage profile (figure 5A) of the battery during the first battery discharge sequence 10.

Furthermore, the method comprises a second step S20 of performing a second electrical load test of the battery 2 by executing a second battery discharge sequence 15 including a time period 16 of continuous discharge current 17 and at least one transient discharge pulse 18, while registering parameters characterising a discharge current profile (figure 6B) and discharge voltage profile (figure 6A) of the battery during the second battery discharge sequence 15.

Furthermore, the method comprises a third step S30 of determining a value of a continuous battery coefficient reflecting a ratio of battery internal resistance to continuous discharge current [Ω/A] based on said registered parameters.

Furthermore, the method comprises a fourth step S40 of determining a value of a transient battery coefficient reflecting a ratio of battery internal resistance to transient discharge current [Ω/A] based on said registered parameters.

Moreover, the method comprises a fifth step S50 of obtaining information about a maximum expected continuous load current $I_{con\_new}$ and maximum expected transient load current $I_{trans\_new}$ of the vehicle electrical circuit.

In addition, the method comprises a sixth step S60 of calculating an estimate of the minimum continuous supply voltage $U_{min\_con}$ from the battery using said continuous battery coefficient and said maximum expected continuous load current $I_{con\_new}$, and calculating a minimum transient supply voltage $U_{min\_trans}$ from the battery using said transient battery coefficient and said maximum expected transient load current $I_{trans\_new}$, when the battery 2 is connected and supplying electrical power to said vehicle electrical circuit 1.

For each of the first and second battery tests, the DC test load may be configured to produce a constant continuous discharge current during said time period 11, 16 of continuous discharge current 12, 17. According to some example embodiments, the DC test load may even be configured to produce a constant continuous discharge current over a plurality of consecutive time periods 11, 16 of continuous discharge current 12, 17.

The transient discharge pulse 13, 18 of each of the first and second battery discharge sequences 10, 15 may be a single pulse occurring in connection with the time period 11, 16 of the continuous discharge current 12, 17, or a plurality of transient discharge pulses 13, 18 occurring periodically or intermittently between consecutive time periods 11, 16 of continuous discharge current 12, 17.

The transient discharge pulses 13, 18 are thus generally periodic transient discharge current pulses that is superposed on the continuous discharge current 12, 17.

The time duration of a transient discharge pulses 13, 18 is generally significantly shorter than the time period 11, 16 of the continuous discharge current 12, 17.

For example, a time length 11, 16 of the continuous discharge current of the first and/or second battery discharge sequence may be at least 10 seconds, specifically at least 30 seconds, and more specifically at least 60 seconds.

Furthermore, a time length of the transient discharge current $I_{trans\_1}$, $_{trans\_2}$ of the first and/or second battery discharge sequence may be is less than 5 seconds, specifically less than 3 seconds, and more specifically in the range of 0.1 - 2.0 ms.

As illustrated in figures 5A-5B and 6A-6B, the first and second battery tests may be implemented in form of constant current battery test. However, the first and second battery tests may be implemented in other ways, such as a constant voltage battery test, constant resistance battery test or constant power battery test, or a combination thereof.

According to some example embodiments, each of the first and second electrical load test of the battery is performed by first ensuring connection of the battery to an electrical load test circuit.

Furthermore, according to some example embodiments, the electrical load test circuit includes a programmable DC-load that is programmed to execute said first and second battery discharge sequences.

The programmable DC-load further may further be programmed to register said parameters characterising] the discharge current profile and discharge voltage profile of the battery during said first and second battery discharge sequences, and to store said parameters with a time stamp.

The parameters characterising the discharge current profile and discharge voltage profile of the battery during the first and second battery discharge sequences refers for example to parameters indicating or reflecting said discharge current profile and discharge voltage profile of the battery.

For example, with reference again to figures 5A-5B, the step of registering parameters characterising the discharge current profile and discharge voltage profile of the battery during the first battery discharge sequence may involve registering a first battery open-circuit voltage $U_{OCV1}$ at time t1, registering a first battery continuous discharge voltage $U_{con\_1}$ and a first battery continuous discharge current $I_{con\_1}$ of said continuous discharge current at time t3, and registering a first battery transient discharge voltage $U_{trans\_1}$ and a first battery transient discharge current $I_{trans\_1}$ of said transient discharge pulse at time t4.

By analogy and with reference to figures 6A-6B, the step of registering parameters characterising the discharge current profile and discharge voltage profile of the battery during the second battery discharge sequence may involve registering a second battery open-circuit voltage $U_{OCV2}$ at time t1, registering a second battery continuous discharge voltage $U_{con\_2}$ and a second battery continuous discharge current $I_{con\_2}$ of said continuous discharge current at time t3, and registering a second battery transient discharge voltage $U_{trans\_2}$ and a second battery transient discharge current $I_{trans\_2}$ of said transient discharge pulse at time t4.

In the example embodiment of figures 5A-5B, the first battery open-circuit voltage $U_{OCV1}$ is 13.4 V, the first battery continuous discharge voltage $U_{con\_1}$ is about 11.5 V, the first battery transient discharge voltage $U_{trans\_1}$ is about 11.0 V, the first battery continuous discharge current $I_{con\_1}$ is about 200 A, the first battery transient discharge current $I_{trans\_1}$ is about 300 A.

In the example embodiment of figures 6A-6B, the second battery open-circuit voltage $U_{OCV2}$ is about 13.4 V, the second battery continuous discharge voltage $U_{con\_2}$ is about 11.8 V, the second battery transient discharge voltage $U_{trans\_2}$ is about 11.3 V, the second battery continuous discharge current $I_{con\_2}$ is about 120 A, and the second battery transient discharge current $I_{trans\_2}$ is about 240 A.

The first and second battery discharge sequences described with reference to figures 5a-5B and 6A-6B are merely one possible way for implementing the first and second discharge sequences, and many alterative options are possible. However, these two examples may be described more in detail. Specifically, at time t0, the load test has not yet begun and the discharge current is this nil. At this stage, the output battery voltage corresponds to a battery open circuit voltage (OCV). This value $U_{OCV1}$, $U_{OCV2}$ of the battery is registered at time t1.

At time t2, the circuit is closed and a discharge current starts flowing in the test circuit.

The battery open-circuit voltage $U_{OCV1}$ at tine t1 is thus measured and registered before starting said first discharge sequence, which occurs at time t2.

At time t3, the first and second battery continuous discharge voltage $U_{con\_1}$, $U_{con\_2}$ and a first and second battery continuous discharge current $I_{con\_1}$, $I_{con\_2}$ are registered.

At time t4, the first and second battery transient discharge voltage $U_{trans\_1}$, $U_{trans\_2}$ and first and second battery transient discharge current $I_{trans\_1}$, $I_{trans\_2}$ of said transient discharge pulse are registered.

Time t5, and further time points, refers to subsequent transient discharge pulses.

In some example embodiments, it may be preferred to register the first and second battery continuous discharge voltage $U_{con\_2}$ and first and second battery continuous discharge current $I_{con\_2}$ of said continuous discharge current, i.e. time t3, relatively close the time t2, because then the state of charge of the battery 2 has not yet changed significantly, compared to the voltage and current level shortly after time t2.

The time period 19 between t2 and t3 is for example in the range of about 0.1 - 5 minutes for avoiding any immediate transient current pulse and reduced influence of the decreased battery output voltage over time.

The time period 20 between t3 and t4 is for example in the range of about 0.5 - 5 minutes for reduced influence of the decreased battery output voltage over time.

The specific form and profile of the first and second electrical load tests provided by the load test circuit may vary to a great extent as long as both continuous and transient loads are provided.

Furthermore, in some example embodiments, the maximum expected continuous load current of the vehicle electrical circuit 1 may be selected to be located within boundaries of the registered first and second battery continuous discharge current $I_{con\_1}$, $I_{con\_2}$, and wherein the maximum expected transient load current of the vehicle electrical circuit 1 may be selected to be located within boundaries of the registered first and second battery transient discharge current $I_{trans\_1}$, $I_{trans\_2}$.

In other words, in some example embodiments, the first and second battery continuous discharge currents $I_{con\_1}$, $I_{con\_2}$, and first and second battery transient discharge currents $I_{trans\_1}$, $I_{trans\_2}$ may be selected such that the maximum expected continuous load current $I_{con\_new}$ and maximum expected transient load current $I_{trans\_new}$ fulfils the following boundary condition:

$$I_{con\_2} \leq I_{con\_new} \leq I_{con\_1}$$

$$I_{trans\_2} \leq I_{trans\_new} \leq I_{trans\_1}.$$

Consequently, in some example embodiments, the electrical load test circuit is configured to cause, during said first battery discharge sequence, a first battery transient discharge current $I_{trans\_1}$ that is about 10-100% larger, specifically about 25-75% larger, and more specifically about 40-60% larger, than the first battery continuous discharge current $I_{con\_1}$. In other words, the first battery discharge sequence may be specifically designed to test the battery output voltage having a relatively high continuous current load and a relative low transient current pulse.

Similarly, in some example embodiments, the electrical load test circuit is configured to cause, during said second battery discharge sequence, a second battery transient discharge current $I_{trans\_2}$ that is about 70-200% larger, specifically about 80-160% larger, and more specifically about 90-120% larger, than the second battery continuous discharge current $I_{trans\_2}$. In other words, the second battery discharge sequence may be specifically designed to test the battery output voltage having a relatively low continuous current load and a relative high transient current pulse.

As a result, in some example embodiments, a magnitude of the first continuous discharge current $I_{con\_1}$ is at least 25% larger, specifically at least 50% larger, or at least 50A larger, specifically at least 100A larger, than the magnitude of the second continuous discharge current $I_{con\_2}$.

Moreover, in some example embodiments, a difference in magnitude between the second battery transient discharge current $I_{trans\_2}$ and the second battery continuous discharge current $I_{con\_2}$ is at least 10% larger, specifically at least 25% larger, or at least 10A larger, specifically at least 25A larger, than difference in magnitude between the first battery transient discharge current $I_{trans\_1}$ and the first battery continuous discharge current $I_{con\_1}$.

In the example battery tests illustrated in figure 5A-5B and 6A-6B a plurality of transient current pulses are included. However, the first and/or second battery discharge sequences may alternatively include merely a single transient current pulse.

The above-mentioned continuous and transient battery coefficients herein refers to a battery coefficient indicating or characterising the ratio of battery internal resistance to continuous or transient discharge current.

According to some example embodiments, the value of the continuous battery coefficient may be determined based on the registered first and second battery open-circuit voltage $U_{OCV1}$, $U_{OCV2}$, the registered first and second battery continuous discharge voltage $U_{con\_1}$, $U_{con\_2}$, and the registered first and second battery continuous discharge current $I_{con\_1}$, $I_{con\_2}$.

Similarly, according to some example embodiments, the value of the transient battery coefficient may be determined based on the registered first and second battery continuous discharge voltage $U_{con\_1}$, $U_{con\_2}$, the registered first and second battery transient discharge voltage $U_{trans\_1}$, $U_{trans\_2}$, and the registered first and second battery transient discharge current $I_{trans\_1}$, $I_{trans\_2}$.

Specifically, according to some example embodiments, the value of the continuous battery coefficient may be determined based on following equation:

$$Battery\ coefficient_{Con} = \frac{|\Delta R_{Continuous}|}{|\Delta I_{Continuous}|} = \frac{|R_1 - R_3|}{|I_{Con\_1} - I_{Con\_2}|} \quad [^{\Omega}/_A]$$

wherein

$$R_1 = \frac{U_{OCV1} - U_{Con\_1}}{I_{Con\_1}}$$

$$R_3 = \frac{U_{OCV2} - U_{Con\_2}}{I_{Con\_2}}$$

$U_{OCV1}$ = the registered first battery open-circuit voltage,
$U_{OCV2}$ = the registered second battery open-circuit voltage
$U_{con\_1}$ = the registered first battery continuous discharge voltage,
$U_{con\_2}$ = the registered second battery continuous discharge voltage
$I_{con\_1}$ = the registered first battery continuous discharge current
$I_{con\_2}$ = the registered second battery continuous discharge current.

Similarly, the value of the transient battery coefficient may be determined based on following equation:

$$Battery\ coefficient_{Trans} = \frac{|\Delta R_{Transient}|}{|\Delta I_{Transient}|} = \frac{|R_2 - R_4|}{|I_{Trans\_1} - I_{Trans\_2}|} \quad [^{\Omega}/_A]$$

wherein

$$R_2 = \frac{U_{Con\_1} - U_{Trans\_1}}{I_{Trans\_1}}$$

$$R_4 = \frac{U_{Con\_2} - U_{Trans\_2}}{I_{Trans\_2}}$$

and wherein

$U_{con\_1}$ = the registered first battery continuous discharge voltage
$U_{con\_2}$ = the registered second battery continuous discharge voltage
$U_{trans\_1}$ = first battery transient discharge voltage
$U_{trans\_2}$ = second battery transient discharge voltage
$I_{trans\_1}$ = the registered first battery transient discharge current
$I_{trans\_2}$ = the registered second battery transient discharge current.

The above-mentioned sixth step S60 of calculating an estimate of the minimum continuous supply voltage $U_{min\_con}$ from the battery using said continuous battery coefficient and said maximum expected continuous load current $I_{con\_new}$, and calculating a minimum transient supply voltage $U_{min\_trans}$ from the battery using said transient battery coefficient and said maximum expected transient load current $I_{trans\_new}$, based on following equations:

$$U_{min\_con} = U_{OCV1} - \left(R_1 - \left(Battery\ coef_{Con} \cdot \left|I_{con\_new} - I_{con\_1}\right|\right)\right) \cdot I_{con\_new}$$

$U_{min\_trans} = U_{min\_con} - (R_2 - (Batterycoef_{Trans} \cdot |I_{trans\_new} - I_{trans\_1}|)) \cdot I_{trans\_new}$

wherein

$U_{OCV1}$ = the registered first battery open-circuit voltage,

$$R_1 = \frac{U_{OCV1} - U_{Con\_1}}{I_{Con\_1}}$$

$$R_2 = \frac{U_{Con\_1} - U_{Trans\_1}}{I_{Trans\_1}}$$

$U_{OCV1}$ = the registered first battery open-circuit voltage
$U_{con\_1}$ = the registered first battery continuous discharge voltage
$I_{con\_1}$ = the registered first battery continuous discharge current
$U_{trans\_1}$ = first battery transient discharge voltage
$I_{trans\_1}$ = the registered first battery transient discharge current
Battery $coef_{con}$ = the continuous battery coefficient
Battery $coef_{trans}$ = the transient battery coefficient
$I_{con\_new}$ = the maximum expected continuous load current
$I_{trans\_new}$ = the maximum expected transient load current.

As briefly mentioned above, the battery State of Charge (SoC) level and/or the battery temperature may in certain implementations be relevant parameters for taking into account when estimating the minimum continuous and transient supply voltage from the battery. Decreased battery SoC generally results in lower minimum continuous and transient supply voltage from the battery. Similarly, decreased battery temperature generally results in lower minimum continuous and transient supply voltage from the battery.
In applications where the low-voltage battery 2 during normal vehicle operation is held in fully or at least near fully charged condition, the risk for low SoC of the battery 2 is low, but may possibly nevertheless happen if for example the vehicle recently has been long term parked or the like, thereby causing the SoC of the battery 2 to slowly sink. Low operating temperature of the battery 2 is likely occurring more frequently.

Consequently, the above-described method for calculating an estimate of the minimum continuous and transient supply voltage from the battery may have to be modified for taking also battery SoC and/or battery operating temperature into account. This may for example be performed by modifying the equations for calculating the continuous and transient battery coefficients to take also battery SoC and/or battery operating temperature into account.

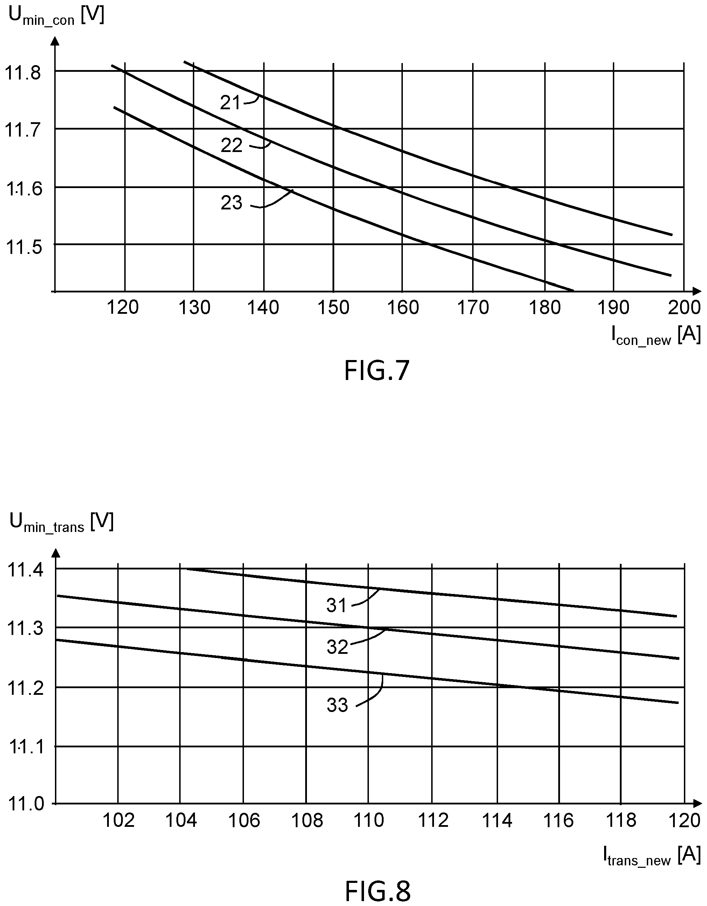

Graph 21 in figure 7 schematically shows an estimation of the minimum continuous supply voltage $U_{min\_con}$ from the battery 2 as a function of the maximum expected continuous load current $I_{con\_new}$, based on the experimental data received from the two battery tests described with reference to figures 5A-5B and 6A-6B, while using the method and equations described above, wherein battery SoC is 100% and battery operating temperature is 20° C.

Graph 22 in figure 7 schematically shows an estimation of the minimum continuous supply voltage $U_{min\_con}$ from the battery 2 as a function of the maximum expected continuous load current $I_{con\_new}$, based on experimental data performed using a battery with significantly reduced SoC and battery operating temperature of 20° C, and graph 23 in figure 7 schematically shows an estimation of the minimum continuous supply voltage $U_{min\_con}$ from the battery 2 as a function of the maximum expected continuous load current $I_{con\_new}$, based on experimental data performed using a battery with significantly reduced SoC in combination with significantly reduced battery operating temperature.

Similarly, graph 31 in figure 8 schematically shows an estimation of the minimum transient supply voltage $U_{min\_trans}$ from the battery 2 as a function of the maximum expected transient load current $I_{trans\_new}$, based on the experimental data received from the two battery tests described with reference to figures 5A-5B and 6A-6B, while using the method and equations described above, wherein battery SoC is 100% and battery operating temperature is 20° C.

Graph 32 in figure 8 schematically shows an estimation of the minimum transient supply voltage $U_{min\_trans}$ from the battery 2 as a function of the maximum expected transient load current $I_{trans\_new}$, based on experimental data performed using a battery with significantly reduced SoC and battery operating temperature of 20° C, and graph 33 in figure 8 schematically shows an estimation of the minimum transient supply voltage $U_{min\_trans}$ from the battery 2 as a function of the maximum expected transient load current $I_{trans\_new}$, based on experimental data performed using a battery with significantly reduced SoC in combination with significantly reduced battery operating temperature.

Consequently, the method for calculating an estimate of the minimum continuous and transient supply voltage from the battery may have to be modified for taking also battery SoC and/or battery operating temperature into account. In other words, the method may further comprise, for each of a plurality of different battery state of charge (SoC) levels and/or for each of a plurality of different battery operating temperature levels, calculating an estimate of the minimum continuous supply voltage from the battery using said continuous battery coefficient and said maximum expected continuous load current, and calculating a minimum transient supply voltage from the battery using said transient battery coefficient and said maximum expected transient load current, when the battery is connected and supplying electrical power to said vehicle electrical circuit.

The above-described method for calculating an estimate of the minimum continuous and transient supply voltage from the battery may be partly or whole implemented and performed by a computer system. For example, with reference to figure 4, the first and second steps S10, S20 involving performing the first and second electrical load test of the battery 2 may for example be performed by a programmable DC electric load tester. Method steps S30 and S40 involving determining a value of the continuous battery coefficient and transient battery coefficient reflecting a ratio of battery internal resistance to transient discharge current based on said registered parameters may be performed by a computer upon receiving experimental test data from the a programmable DC electric load tester. Method step S50 of obtaining information about a maximum expected continuous load current $I_{con\_new}$ and maximum expected transient load current $I_{trans\_new}$ of the vehicle electrical circuit may be accomplished by having a user inputting data at a HMI interface, or by having a computer program calculating said maximum expected continuous and transient load current $I_{con\_new}$, $I_{trans\_new}$ based on information about the electrical loads and their current profiles of the vehicle electric circuit. Finally, step S60 of calculating an estimate of the minimum continuous and transient supply voltage from the battery may be performed by a computer upon information about said continuous and transient battery coefficients and said maximum expected continuous and transient load currents.

In other words, the step of determining a value of the continuous battery coefficient and a value of the transient battery coefficient is performed by means of a computer system.

Similarly, the step of obtaining information about a maximum expected continuous load current $I_{con\_new}$ and maximum expected transient load current $I_{trans\_new}$ of the vehicle electrical circuit is performed by means of a computer system.

In addition, the step of calculating an estimate of the minimum continuous supply voltage from the battery and calculating a minimum transient supply voltage from the battery, is performed by means of a computer system.

The present disclosure also relates to a method for selecting an appropriate battery type and/or size for powering a vehicle electrical circuit. According to some example embodiments, with reference to figure 9, this method comprises a first step S100 of determining a maximum expected continuous load current $I_{con\_new}$ and maximum expected transient load current $I_{trans\_new}$ of the vehicle electrical circuit. This may for example be performed by determining maximum expected continuous load current $I_{con\_new}$ and maximum expected transient load current $I_{trans\_new}$ for each electrical component of the vehicle electrical circuit, and subsequently calculating a total accumulated maximum expected continuous load current $I_{con\_new}$ and a total maximum expected transient load current $I_{trans\_new}$ based on the current profiles of each individual electrical load.

The method further comprises a second step S200 of identifying a battery that has a minimum continuous supply voltage and a minimum transient supply voltage, when the battery is connected and supplying electrical power to said vehicle electrical circuit, that are larger than said maximum expected continuous load current $I_{con\_new}$ and maximum expected transient load current $I_{trans\_new}$ of the vehicle electrical circuit, using the method according to any of the embodiments described above. For example, the second step S200 may be performed by iteratively applying the method steps S10-S60 described above with reference to figure 4 for various battery types/sizes until said criteria has been fulfilled.

The present disclosure also relates to a method for manufacturing a vehicle comprising of installing a battery in the vehicle and connecting the battery to a vehicle electrical circuit, wherein the battery has been selected using the method according to any of the embodiments described above.

In other words, and with reference to figure 10, this method may be deemed comprises a first step S1000 of selecting an appropriate battery type and/or size for powering a vehicle electrical circuit, as described above with reference to figure 9, and a second step S2000 of installing the selected battery in the vehicle and connecting the battery to a vehicle electrical circuit.

The present disclosure also relates to a computer system comprising a processor configured for estimating a minimum continuous and transient supply voltage of a battery when the battery is connected and supplying electrical power to a vehicle electrical circuit, wherein the computer system being configured for: receiving battery parameters characterising a discharge current profile and discharge voltage profile of the battery registered while performing a first electrical load test of the battery by executing a first battery discharge sequence including a continuous discharge current and at least one transient discharge pulse; receiving battery parameters characterising a discharge current profile and discharge voltage profile of the battery registered while performing a second electrical load test of the battery by executing a second battery discharge sequence including a continuous discharge current and at least one transient discharge pulse, determining a value of a continuous battery coefficient reflecting a ratio of battery internal resistance to continuous discharge current $[\Omega/A]$ based on said received parameters; determining a value of a transient battery coefficient reflecting a ratio of battery internal resistance to transient discharge current $[\Omega/A]$ based on said received parameters; obtaining information about a maximum expected continuous load current $I_{con\_new}$ and maximum expected transient load current $I_{trans\_new}$ of the vehicle electrical circuit; calculating an estimate of the minimum continuous supply voltage from the battery using said continuous battery coefficient and said maximum expected continuous load current $I_{con\_new}$, and calculating a minimum transient supply voltage from the battery using said transient battery coefficient and said maximum expected transient load current $I_{trans\_new}$, when the battery is connected and supplying electrical power to said vehicle electrical circuit.

The present disclosure has been presented above with reference to specific embodiments. However, other embodiments than the above described are possible and within the scope of the disclosure. Different method steps than those described above, performing the method by hardware or software, may be provided within the scope of the disclosure. Thus, according to an exemplary embodiment, there is provided a non-transitory computer-readable storage medium storing one or more programs configured to be executed by one or more processors of the computer system, the one or more programs comprising instructions for performing the method according to any one of the above-discussed embodiments. Alternatively, according to another exemplary embodiment a cloud computing system can be configured to perform any of the method aspects presented herein. The cloud computing system may comprise distributed cloud computing resources that jointly perform the method aspects presented herein under control of one or more computer program products.

Moreover, the processor may be connected to one or more communication interfaces and/or sensor interfaces for receiving and/transmitting data with external entities such as e.g. sensors arranged on the vehicle surface, an off-site server, or a cloud-based server.

The processor(s) associated with the computer system may be or include any number of hardware components for conducting data or signal processing or for executing computer code stored in memory. The system may have an associated memory, and the memory may be one or more devices for storing data and/or computer code for completing or facilitating the various methods described in the present description. The memory may include volatile memory or non-volatile memory. The memory may include database components, object code components, script components, or any other type of information structure for supporting the various activities of the present description. According to an exemplary embodiment, any distributed or local memory device may be utilized with the systems and methods of this description. According to an exemplary embodiment the memory is communicably connected to the processor (e.g., via a circuit or any other wired, wireless, or network connection) and includes computer code for executing one or more processes described herein.

It will be appreciated that the above description is merely exemplary in nature and is not intended to limit the present disclosure, its application or uses. While specific examples have been described in the specification and illustrated in the drawings, it will be understood by those of ordinary skill in the art that various changes may be made and equivalents may be substituted for elements thereof without departing from the scope of the present disclosure as defined in the claims. Furthermore, modifications may be made to adapt a particular situation or material to the teachings of the present disclosure without departing from the essential scope thereof. Although discussed above as methods described by the flowchart of figures 5, 9 and 10, it should be appreciated that one or more operations may be omitted from the methods discussed. Further, the operations may be performed in any order and do not necessarily imply an order as provided. Rather, the methods discussed are merely one embodiment of the present disclosure as contemplated.

Therefore, it is intended that the present disclosure not be limited to the particular examples illustrated by the drawings and described in the specification as the best mode presently contemplated for carrying out the teachings of the present disclosure, but that the scope of the present disclosure will include any embodiments falling within the foregoing description and the appended claims. The invention is defined by the claims. Reference signs mentioned in the claims should not be seen as limiting the extent of the matter protected by the claims, and their sole function is to make claims easier to understand.

**Claims**

1.  A method for estimating a minimum continuous and transient supply voltage ($U_{min\_con}$, $U_{min\_trans}$) of a battery (2) when the battery (2) is connected and supplying electrical power to a vehicle electrical circuit (1), the method comprising:

    performing a first electrical load test of the battery (2) by executing a first battery discharge sequence (10) including a continuous discharge current (12) and at least one transient discharge pulse (13), while registering parameters characterising a discharge current profile and discharge voltage profile of the battery (2) during the first battery discharge sequence (10),
    performing a second electrical load test of the battery (2) by executing a second battery discharge sequence (15) including a continuous discharge current (17) and at least one transient discharge pulse (18), while registering parameters characterising a discharge current profile and discharge voltage profile of the battery (2) during the second battery discharge sequence (15),
    determining a value of a continuous battery coefficient reflecting a ratio of battery internal resistance to continuous discharge current based on said registered parameters,
    determining a value of a transient battery coefficient reflecting a ratio of battery internal resistance to transient discharge current based on said registered parameters,
    obtaining information about a maximum expected continuous load current ($I_{con\_new}$) and maximum expected transient load current ($I_{trans\_new}$) of the vehicle electrical circuit (1),
    calculating an estimate of the minimum continuous supply voltage ($U_{min\_con}$) from the battery (2) using said continuous battery coefficient and said maximum expected continuous load current ($I_{con\_new}$), and calculating a minimum transient supply voltage ($U_{min\_trans}$) from the battery (2) using said transient battery coefficient and said maximum expected transient load current ($I_{trans\_new}$), when the battery (2) is connected and supplying electrical power to said vehicle electrical circuit (1).

2.  The method according to claim 1,

    wherein the step of registering parameters characterising the discharge current profile and discharge voltage profile of the battery (2) during the first battery discharge sequence (10) involves registering a first battery open-circuit voltage ($U_{OCV1}$), registering a first battery continuous discharge voltage ($U_{con\_1}$) and a first battery continuous discharge current ($I_{con\_1}$) of said continuous discharge current (12), and registering a first battery transient discharge voltage ($U_{trans\_1}$) and a first battery transient discharge current ($I_{trans\_1}$) of said transient discharge pulse (13), and
    wherein the step of registering parameters characterising the discharge current profile and discharge voltage profile of the battery (2) during the second battery discharge sequence (15) involves registering a second battery open-circuit voltage ($U_{OCV2}$), registering a second battery continuous discharge voltage ($U_{con\_2}$) and a second battery continuous discharge current ($I_{con\_2}$) of said continuous discharge current (17), and registering a second battery transient discharge voltage ($U_{trans\_2}$) and a second battery transient discharge current ($I_{trans\_2}$) of said transient discharge pulse (18).

3. The method according to claim 2, wherein the value of the continuous battery coefficient is determined based on the registered first and second battery open-circuit voltage ($U_{OCV1}$, $U_{OCV2}$), the registered first and second battery continuous discharge voltage ($U_{con\_1}$, $U_{con\_2}$), and the registered first and second battery continuous discharge current ($I_{con\_1}$, $I_{con\_2}$).

4. The method according to claim 2 or claim 3, wherein the value of a transient battery coefficient is determined based on the registered first and second battery continuous discharge voltage ($U_{con\_1}$, $U_{con\_2}$), the registered first and second battery transient discharge voltage ($U_{trans\_1}$, $U_{trans\_2}$), and the registered first and second battery transient discharge current ($I_{trans\_1}$, $I_{trans\_2}$).

5. The method according to any of the preceding claims 2-4, wherein the maximum expected continuous load current ($I_{con\_new}$) of the vehicle electrical circuit (1) is selected to be located within boundaries of the registered first and second battery continuous discharge current ($I_{con\_1}$, $I_{con\_2}$), and wherein the maximum expected transient load current ($I_{trans\_new}$) of the vehicle electrical circuit (1) is selected to be located within boundaries of the registered first and second battery transient discharge current ($I_{trans\_1}$, $I_{trans\_2}$).

6. The method according to any of the preceding claims, wherein the method further comprises, for each of a plurality of different battery state of charge (SoC) levels and/or for each of a plurality of different battery temperature levels, calculating an estimate of the minimum continuous supply voltage ($U_{min\_con}$) from the battery (2) using said continuous battery coefficient and said maximum expected continuous load current ($I_{con\_new}$), and calculating a minimum transient supply voltage ($U_{min\_trans}$) from the battery (2) using said transient battery coefficient and said maximum expected transient load current ($I_{trans\_new}$), when the battery (2) is connected and supplying electrical power to said vehicle electrical circuit (1).

7. The method according to any of the preceding claims, wherein each of the first and second electrical load test of the battery (2) is performed by first ensuring connection of the battery (2) to an electrical load test circuit.

8. The method according to claim 7, the electrical load test circuit includes a programmable DC-load (6) that is programmed to execute said first and second battery discharge sequences (10, 15).

9. The method according to claim 7 or claim 8,

   wherein the electrical load test circuit is configured to cause, during said first battery discharge sequence (10), a first battery transient discharge current ($I_{trans\_1}$) that is about 10-100% larger, specifically about 25-75% larger, and more specifically about 40-60% larger, than the first battery continuous discharge current ($I_{con\_1}$), and/or wherein the electrical load test circuit is configured to cause, during said second battery discharge sequence (15), a second battery transient discharge current ($I_{trans\_2}$) that is about 70-200% larger, specifically about 80-160% larger, and more specifically about 90-120% larger, than the second battery continuous discharge current ($I_{trans\_2}$).

10. The method according to any of the preceding claims 2-9, wherein a magnitude of the first continuous discharge current ($I_{con\_1}$) is at least 25% larger, specifically at least 50% larger, or at least 50A larger, specifically at least 100A larger, than the magnitude of the second continuous discharge current ($I_{con\_2}$).

11. The method according to any of the preceding claims 2 -10, wherein a difference in magnitude between the second battery transient discharge current ($I_{trans\_2}$ and the second battery continuous discharge current ($I_{con\_2}$) is at least 10% larger, specifically at least 25% larger, or at least 10A larger, specifically at least 25A larger, than difference in magnitude between the first battery transient discharge current ($I_{trans\_1}$) and the first battery continuous discharge current ($I_{con\_1}$).

12. The method according to any of the preceding claims, wherein a length (11, 16) of the continuous discharge current (12, 17) of the first and/or second battery discharge sequence (10, 15) is at least 10 seconds, specifically at least 30 seconds, and more specifically at least 60 seconds, and wherein a length of the transient discharge current pulse (13, 18) of the first and/or second battery discharge sequence (10, 15) is less than 5 seconds, specifically less than 3 seconds, and more specifically in the range of 0.1 - 2.0 ms.

13. A method for selecting an appropriate battery type and/or size for powering a vehicle electrical circuit (1), the method comprises:

determining a maximum expected continuous load current ($I_{con\_new}$) and maximum expected transient load current ($I_{trans\_new}$) of the vehicle electrical circuit (1),

identifying a battery (2) that has a minimum continuous supply voltage ($U_{min\_con}$) and a minimum transient supply voltage ($U_{min\_trans}$), when the battery (2) is connected and supplying electrical power to said vehicle electrical circuit (1), that are larger than said maximum expected continuous load current ($I_{con\_new}$) and maximum expected transient load current ($I_{trans\_new}$) of the vehicle electrical circuit (1), using the method of any of claims 1 - 12.

14. A method for manufacturing a vehicle comprising installing a battery (2) in the vehicle and connecting the battery (2) to a vehicle electrical circuit (1), wherein the battery (2) has been selected using the method of claim 13.

15. A computer system comprising a processor configured for estimating a minimum continuous and transient supply voltage ($U_{min\_con}$, $U_{min\_trans}$) of a battery (2) when the battery (2) is connected and supplying electrical power to a vehicle electrical circuit (1), the computer system being configured for:

receiving battery parameters characterising a discharge current profile and discharge voltage profile of the battery (2) registered while performing a first electrical load test of the battery (2) by executing a first battery discharge sequence (10) including a continuous discharge current (12) and at least one transient discharge pulse (13),

receiving battery parameters characterising a discharge current profile and discharge voltage profile of the battery (2) registered while performing a second electrical load test of the battery (2) by executing a second battery discharge sequence (15) including a continuous discharge current (17) and at least one transient discharge pulse (18),

determining a value of a continuous battery coefficient reflecting a ratio of battery internal resistance to continuous discharge current [$\Omega$/A] based on said received parameters,

determining a value of a transient battery coefficient reflecting a ratio of battery internal resistance to transient discharge current [$\Omega$/A] based on said received parameters,

obtaining information about a maximum expected continuous load current ($I_{con\_new}$) and maximum expected transient load current ($I_{trans\_new}$) of the vehicle electrical circuit (1),

calculating an estimate of the minimum continuous supply voltage ($U_{min\_con}$) from the battery (2) using said continuous battery coefficient and said maximum expected continuous load current ($I_{con\_new}$), and calculating a minimum transient supply voltage ($U_{min\_trans}$) from the battery (2) using said transient battery coefficient and said maximum expected transient load current ($I_{trans\_new}$), when the battery (2) is connected and supplying electrical power to said vehicle electrical circuit (1).

## Patentansprüche

1. Verfahren zum Schätzen einer kontinuierlichen und transienten Mindestversorgungsspannung ($U_{min\_con}$, $U_{min\_trans}$) einer Batterie (2), wenn die Batterie (2) an einen Fahrzeugstromkreis (1) angeschlossen ist und diesen mit elektrischer Leistung versorgt, wobei das Verfahren Folgendes umfasst:

Durchführen eines ersten Tests elektrischer Verbraucher der Batterie (2) durch Ausführen einer ersten Batterie-Entladesequenz (10), die einen kontinuierlichen Entladestrom (12) und mindestens einen transienten Entladeimpuls (13) beinhaltet, wobei Parameter, die ein Entladestromprofil und ein Entladespannungsprofil der Batterie (2) während der ersten Batterie-Entladesequenz (10) charakterisieren, registriert werden,

Durchführen eines zweiten Tests elektrischer Verbraucher der Batterie (2) durch Ausführen einer zweiten Batterie-Entladesequenz (15), die einen kontinuierlichen Entladestrom (17) und mindestens einen transienten Entladeimpuls (18) beinhaltet, wobei Parameter, die ein Entladestromprofil und ein Entladespannungsprofil der Batterie (2) während der zweiten Batterie-Entladesequenz (15) charakterisieren, registriert werden,

Bestimmen eines Wertes eines kontinuierlichen Batteriekoeffizienten, der ein Verhältnis eines Innenwiderstands der Batterie zu kontinuierlichem Entladestrom widerspiegelt, basierend auf den registrierten Parametern,

Bestimmen eines Wertes eines transienten Batteriekoeffizienten, der ein Verhältnis eines Innenwiderstands der Batterie zu transientem Entladestrom widerspiegelt, basierend auf den registrierten Parametern,

Erlangen von Informationen über einen erwarteten kontinuierlichen Höchstbelastungsstrom ($I_{con\_new}$) und einen erwarteten transienten Höchstbelastungsstrom ($I_{trans\_new}$) des Fahrzeugstromkreises (1),

Berechnen einer Schätzung der kontinuierlichen Mindestversorgungsspannung ($U_{min\_con}$) von der Batterie (2) unter Verwendung des kontinuierlichen Batteriekoeffizienten und des erwarteten kontinuierlichen Höchstbelastungsstroms ($I_{con\_new}$) und Berechnen einer transienten Mindestversorgungsspannung ($U_{min\_trans}$) von der Batterie (2) unter Verwendung des transienten Batteriekoeffizienten und des erwarteten transienten Höchstbelastungsstroms ($I_{trans\_new}$), wenn die Batterie (2) an den Fahrzeugstromkreis (1) angeschlossen ist und diesen mit elektrischer Leistung versorgt.

2. Verfahren nach Anspruch 1,

   wobei der Schritt des Registrierens von Parametern, die das Entladestromprofil und das Entladespannungsprofil der Batterie (2) während der ersten Batterie-Entladesequenz (10) charakterisieren, Registrieren einer ersten Batterie-Leerlaufspannung ($U_{OCV1}$), Registrieren einer ersten kontinuierlichen Batterie-Entladespannung ($U_{con\_1}$) und eines ersten kontinuierlichen Batterie-Entladestroms ($I_{con\_1}$) des kontinuierlichen Entladestroms (12) und Registrieren einer ersten transienten Batterie-Entladespannung ($U_{trans\_1}$) und eines ersten transienten Batterie-Entladestroms ($I_{trans\_1}$) des transienten Entladeimpulses (13) involviert und
   wobei der Schritt des Registrierens von Parametern, die das Entladestromprofil und das Entladespannungsprofil der Batterie (2) während der zweiten Batterie-Entladesequenz (15) charakterisieren, Registrieren einer zweiten Batterie-Leerlaufspannung ($U_{OCV2}$), Registrieren einer zweiten kontinuierlichen Batterie-Entladespannung ($U_{con\_2}$) und eines zweiten kontinuierlichen Batterie-Entladestroms ($I_{con\_2}$) des kontinuierlichen Entladestroms (17) und Registrieren einer zweiten transienten Batterie-Entladespannung ($U_{trans\_2}$) und eines zweiten transienten Batterie-Entladestroms ($I_{trans\_2}$) des transienten Entladeimpulses (18) involviert.

3. Verfahren nach Anspruch 2, wobei der Wert des kontinuierlichen Batteriekoeffizienten basierend auf der registrierten ersten und zweiten Batterie-Leerlaufspannung ($U_{OCV1}$, $U_{OCV2}$), der registrierten ersten und zweiten kontinuierlichen Batterie-Entladespannung ($U_{con\_1}$, $U_{con\_2}$) und dem registrierten ersten und zweiten kontinuierlichen Batterie-Entladestrom ($I_{con\_1}$, $I_{con\_2}$) bestimmt wird.

4. Verfahren nach Anspruch 2 oder Anspruch 3, wobei der Wert eines transienten Batteriekoeffizienten basierend auf der registrierten ersten und zweiten kontinuierlichen Batterie-Entladespannung ($U_{con\_1}$, $U_{con\_2}$), der registrierten ersten und zweiten transienten Batterie-Entladespannung ($U_{trans\_1}$, $U_{trans\_2}$) und dem registrierten ersten und zweiten transienten Batterie-Entladestrom ($I_{trans\_1}$, $I_{trans\_2}$) bestimmt wird.

5. Verfahren nach einem der vorhergehenden Ansprüche 2-4, wobei der erwartete kontinuierliche Höchstbelastungsstrom ($I_{con\_new}$) des Fahrzeugstromkreises (1) so ausgewählt ist, dass er innerhalb von Grenzen des registrierten ersten und zweiten kontinuierlichen Batterie-Entladestroms ($I_{con\_1}$, $I_{con\_2}$) liegt, und wobei der erwartete transiente Höchstbelastungsstrom ($I_{trans\_new}$) des Fahrzeugstromkreises (1) so ausgewählt ist, dass er innerhalb von Grenzen des registrierten ersten und zweiten transienten Batterie-Entladestroms ($I_{trans\_1}$, $I_{trans\_2}$) liegt.

6. Verfahren nach einem der vorhergehenden Ansprüche, wobei das Verfahren ferner für jeden einer Vielzahl von unterschiedlichen Batterieladezustands(SoC)-Pegeln und/oder für jeden einer Vielzahl von unterschiedlichen Batterietemperaturpegeln Berechnen einer Schätzung der kontinuierlichen Mindestversorgungsspannung ($U_{min\_con}$) von der Batterie (2) unter Verwendung des kontinuierlichen Batteriekoeffizienten und des erwarteten kontinuierlichen Höchstbelastungsstroms ($I_{con\_new}$) und Berechnen einer transienten Mindestversorgungsspannung ($U_{min\_trans}$) von der Batterie (2) unter Verwendung des transienten Batteriekoeffizienten und des erwarteten transienten Höchstbelastungsstroms ($I_{trans\_new}$) umfasst, wenn die Batterie (2) an den Fahrzeugstromkreis (1) angeschlossen ist und diesen mit elektrischer Leistung versorgt.

7. Verfahren nach einem der vorhergehenden Ansprüche, wobei jeder des ersten und zweiten Tests elektrischer Verbraucher der Batterie (2) durchgeführt wird, indem zuerst ein Anschluss der Batterie (2) mit einer Testschaltung elektrischer Verbraucher sichergestellt wird.

8. Verfahren nach Anspruch 7, wobei die Testschaltung elektrischer Verbraucher einen programmierbaren Gleichstromverbraucher (6), der zum Ausführen der ersten und zweiten Batterie-Entladesequenz (10, 15) programmiert ist, beinhaltet.

9. Verfahren nach Anspruch 7 oder Anspruch 8,

   wobei die Testschaltung elektrischer Verbraucher dazu konfiguriert ist, während der ersten Batterie-Entladesequenz (10) einen ersten transienten Batterie-Entladestrom ($I_{trans\_1}$), der etwa 10-100 % größer, insbesondere etwa 25-75 % größer und noch konkreter etwa 40-60 % größer ist als der erste kontinuierliche Batterie-Entladestrom ($I_{con\_1}$), zu verursachen, und/oder
wobei die Testschaltung elektrischer Verbraucher dazu konfiguriert ist, während der zweiten Batterie-Entladesequenz (15) einen zweiten transienten Batterie-Entladestrom ($I_{trans\_2}$), der etwa 70-200 % größer, insbesondere etwa 80-160 % größer und noch konkreter etwa 90-120 % größer ist als der zweite kontinuierliche Batterie-Entladestrom ($I_{trans\_2}$), zu verursachen.

10. Verfahren nach einem der vorhergehenden Ansprüche 2-9, wobei eine Größe des ersten kontinuierlichen Entladestroms ($I_{con\_1}$) mindestens 25 % größer, insbesondere mindestens 50 % größer, oder mindestens 50 A größer, insbesondere mindestens 100 A größer ist als die Größe des zweiten kontinuierlichen Entladestroms ($I_{con\_2}$).

11. Verfahren nach einem der vorhergehenden Ansprüche 2-10, wobei ein Größenunterschied zwischen dem zweiten transienten Batterie-Entladestrom ($I_{trans\_2}$) und dem zweiten kontinuierlichen Batterie-Entladestrom ($I_{con\_2}$) mindestens 10 % größer, insbesondere mindestens 25 % größer, oder mindestens 10 A größer, insbesondere mindestens 25 A größer ist als ein Größenunterschied zwischen dem ersten transienten Batterie-Entladestrom ($I_{trans\_1}$) und dem ersten kontinuierlichen Batterie-Entladestrom ($I_{con\_1}$).

12. Verfahren nach einem der vorhergehenden Ansprüche, wobei eine Länge (11, 16) des kontinuierlichen Entladestroms (12, 17) der ersten und/oder zweiten Batterie-Entladesequenz (10, 15) mindestens 10 Sekunden, insbesondere mindestens 30 Sekunden und noch konkreter mindestens 60 Sekunden beträgt, und wobei eine Länge des transienten Entladestromimpulses (13, 18) der ersten und/oder zweiten Batterie-Entladesequenz (10, 15) weniger als 5 Sekunden, insbesondere weniger als 3 Sekunden und noch konkreter im Bereich von 0,1-2,0 ms beträgt.

13. Verfahren zum Auswählen eines geeigneten Batterietyps und/oder einer geeigneten Batteriegröße zum Antreiben eines Fahrzeugstromkreises (1), wobei das Verfahren Folgendes umfasst:

   Bestimmen eines erwarteten kontinuierlichen Höchstbelastungsstroms ($I_{con\_new}$) und eines erwarteten transienten Höchstbelastungsstroms ($I_{trans\_new}$) des Fahrzeugstromkreises (1),
   Identifizieren einer Batterie (2), die eine kontinuierliche Mindestversorgungsspannung ($U_{min\_con}$) und eine transiente Mindestversorgungsspannung ($U_{min\_trans}$) aufweist, wenn die Batterie (2) an den Fahrzeugstromkreis (1) angeschlossen ist und diesen mit elektrischer Leistung versorgt, die größer sind als der erwartete kontinuierliche Höchstbelastungsstrom ($I_{con\_new}$) und der erwartete transiente Höchstbelastungsstrom ($I_{trans\_new}$) des Fahrzeugstromkreises (1), unter Verwendung des Verfahrens nach einem der Ansprüche 1-12.

14. Verfahren zum Herstellen eines Fahrzeugs, umfassend Installieren einer Batterie (2) in das Fahrzeug und Anschließen der Batterie (2) an einen Fahrzeugstromkreis (1), wobei die Batterie (2) unter Verwendung des Verfahrens nach Anspruch 13 ausgewählt wurde.

15. Computersystem, umfassend einen Prozessor, der dazu konfiguriert ist, eine kontinuierliche und transiente Mindestversorgungsspannung ($U_{min\_con}$, $U_{min\_trans}$) einer Batterie (2) zu schätzen, wenn die Batterie (2) an einen Fahrzeugstromkreis (1) angeschlossen ist und diesen mit elektrischer Leistung versorgt, wobei das Computersystem zu Folgendem konfiguriert ist:

   Empfangen von Batterieparametern, die ein Entladestromprofil und ein Entladespannungsprofil der Batterie (2) charakterisieren, die beim Durchführen eines ersten Tests elektrischer Verbraucher der Batterie (2) durch Ausführen einer ersten Batterie-Entladesequenz (10), die einen kontinuierlichen Entladestrom (12) und mindestens einen transienten Entladeimpuls (13) beinhaltet, registriert wurden,
   Empfangen von Batterieparametern, die ein Entladestromprofil und ein Entladespannungsprofil der Batterie (2) charakterisieren, die beim Durchführen eines zweiten Tests elektrischer Verbraucher der Batterie (2) durch Ausführen einer zweiten Batterie-Entladesequenz (15), die einen kontinuierlichen Entladestrom (17) und mindestens einen transienten Entladeimpuls (18) beinhaltet, registriert wurden,
   Bestimmen eines Wertes eines kontinuierlichen Batteriekoeffizienten, der ein Verhältnis eines Innenwiderstands der Batterie zu kontinuierlichem Entladestrom [Ω/A] widerspiegelt, basierend auf den empfangenen Parametern,
   Bestimmen eines Wertes eines transienten Batteriekoeffizienten, der ein Verhältnis eines Innenwiderstands der Batterie zu transientem Entladestrom [Ω/A] widerspiegelt, basierend auf den empfangenen Parametern,
   Erlangen von Informationen über einen erwarteten kontinuierlichen Höchstbelastungsstrom ($I_{con\_new}$) und einen erwarteten transienten Höchstbelastungsstrom ($I_{trans\_new}$) des Fahrzeugstromkreises (1),
   Berechnen einer Schätzung der kontinuierlichen Mindestversorgungsspannung ($U_{min\_con}$) von der Batterie (2) unter Verwendung des kontinuierlichen Batteriekoeffizienten und des erwarteten kontinuierlichen Höchstbelastungsstroms ($I_{con\_new}$) und Berechnen einer transienten Mindestversorgungsspannung ($U_{min\_trans}$) von der Batterie (2) unter Verwendung des transienten Batteriekoeffizienten und des erwarteten transienten Höchstbelastungsstroms ($I_{trans\_new}$), wenn die Batterie (2) an den Fahrzeugstromkreis (1) angeschlossen ist und diesen mit elektrischer Energie versorgt.

## Revendications

1. Procédé d'estimation d'une tension d'alimentation continue et transitoire minimale ($U_{min\_con}$, $U_{min\_trans}$) d'une batterie (2) lorsque la batterie (2) est connectée et fournit de l'énergie électrique à un circuit électrique de véhicule (1), le procédé comprenant :

   la réalisation d'un premier test de charge électrique de la batterie (2) en exécutant une première séquence de décharge de batterie (10) comportant un courant de décharge continu (12) et au moins une impulsion de décharge transitoire (13), tout en enregistrant des paramètres caractérisant un profil de courant de décharge et profil de tension de décharge de la batterie (2) pendant la première séquence de décharge de batterie (10), la réalisation d'un second test de charge électrique de la batterie (2) en exécutant une seconde séquence de décharge de batterie (15) comportant un courant de décharge continu (17) et au moins une impulsion de décharge transitoire (18), tout en enregistrant des paramètres caractérisant un profil de courant de décharge et profil de tension de décharge de la batterie (2) pendant la seconde séquence de décharge de batterie (15), la détermination d'une valeur d'un coefficient de batterie continu reflétant un rapport entre la résistance interne de la batterie et le courant de décharge continu sur la base desdits paramètres enregistrés, la détermination d'une valeur d'un coefficient de batterie transitoire reflétant un rapport entre la résistance interne de la batterie et le courant de décharge transitoire sur la base desdits paramètres enregistrés, l'obtention d'informations concernant un courant de charge continu maximum attendu ($I_{con\_new}$) et un courant de charge transitoire maximum attendu ($I_{trans\_new}$) du circuit électrique du véhicule (1), le calcul d'une estimation de la tension d'alimentation continue minimale ($U_{min\_con}$) à partir de la batterie (2) en utilisant ledit coefficient de batterie continu et ledit courant de charge continu maximum attendu ($I_{con\_new}$), et le calcul d'une tension d'alimentation transitoire minimale ($U_{min\_trans}$) à partir de la batterie (2) en utilisant ledit coefficient de batterie transitoire et ledit courant de charge transitoire maximum attendu ($I_{trans\_new}$), lorsque la batterie (2) est connectée et fournit de l'énergie électrique audit circuit électrique du véhicule (1).

2. Procédé selon la revendication 1,

   dans lequel l'étape d'enregistrement de paramètres caractérisant le profil de courant de décharge et le profil de tension de décharge de la batterie (2) pendant la première séquence de décharge de batterie (10) implique l'enregistrement d'une première tension en circuit ouvert de batterie ($U_{OCV1}$), l'enregistrement d'une première décharge continue de batterie ($U_{con\_1}$) et un premier courant de décharge continu de batterie ($I_{con\_1}$) dudit courant de décharge continu (12), et l'enregistrement d'une première tension de décharge transitoire de batterie ($U_{trans\_1}$) et d'un premier courant de décharge transitoire de batterie ($I_{trans\_1}$) de ladite impulsion de décharge transitoire (13), et dans lequel l'étape d'enregistrement de paramètres caractérisant le profil de courant de décharge et le profil de tension de décharge de la batterie (2) pendant la seconde séquence de décharge de batterie (15) implique l'enregistrement d'une seconde tension en circuit ouvert de batterie ($U_{OCV2}$), l'enregistrement d'une seconde décharge continue de batterie ($U_{con\_2}$) et un second courant de décharge continu de batterie ($I_{con\_2}$) dudit courant de décharge continu (17), et l'enregistrement d'une seconde tension de décharge transitoire de batterie ($U_{trans\_2}$) et d'un second courant de décharge transitoire de batterie ($I_{trans\_2}$) de ladite impulsion de décharge transitoire (18).

3. Procédé selon la revendication 2, dans lequel la valeur du coefficient de batterie continu est déterminée sur la base de la première et de la seconde tension en circuit ouvert de batterie enregistrées ($U_{OCV1}$, $U_{OCV2}$), de la première et de la seconde tension de décharge continue de batterie enregistrées ($U_{con\_1}$, $U_{con\_2}$), et du premier et du second courant de décharge continu de batterie enregistrés ($I_{con\_1}$, $I_{con\_2}$).

4. Procédé selon la revendication 2 ou la revendication 3, dans lequel la valeur d'un coefficient de batterie transitoire est déterminée sur la base de la première et de la seconde tension de décharge continue de batterie enregistrées ($U_{con\_1}$, $U_{con\_2}$), de la première et de la seconde tension de décharge transitoire de batterie enregistrées ($U_{trans\_1}$, $U_{trans\_2}$), et du premier et du second courant de décharge transitoire de batterie enregistrés ($I_{trans\_1}$, $I_{trans\_2}$).

**5.** Procédé selon l'une quelconque des revendications précédentes 2 à 4, dans lequel le courant de charge continu maximum attendu ($I_{con\_new}$) du circuit électrique du véhicule (1) est sélectionné pour être situé dans les limites des premier et second courants de décharge continus de batterie enregistrés ($I_{con\_1}$, $I_{con\_2}$), et dans lequel le courant de charge transitoire maximal attendu ($I_{trans\_new}$) du circuit électrique du véhicule (1) est sélectionné pour être situé dans les limites des premier et second courants de décharge transitoire de batterie enregistrés ($I_{trans\_1}$, $I_{trans\_2}$).

**6.** Procédé selon l'une quelconque des revendications précédentes, dans lequel le procédé comprend en outre, pour chacun d'une pluralité de niveaux d'état de charge (SoC) de batterie différents et/ou pour chacun d'une pluralité de niveaux de température de batterie différents, le calcul d'une estimation de la tension d'alimentation continue minimale ($U_{min\_con}$) à partir de la batterie (2) en utilisant ledit coefficient de batterie continu et ledit courant de charge continu maximum attendu ($I_{con\_new}$), et le calcul d'une tension d'alimentation transitoire minimale ($U_{min\_trans}$) à partir de la batterie (2) en utilisant ledit coefficient de batterie transitoire et ledit courant de charge transitoire maximum attendu ($I_{trans\_new}$), lorsque la batterie (2) est connectée et fournit de l'énergie électrique audit circuit électrique du véhicule (1).

**7.** Procédé selon l'une quelconque des revendications précédentes, dans lequel chacun des premier et second tests de charge électrique de la batterie (2) est réalisé en assurant d'abord la connexion de la batterie (2) à un circuit de test de charge électrique.

**8.** Procédé selon la revendication 7, dans lequel le circuit de test de charge électrique comporte une charge CC programmable (6) qui est programmée pour exécuter lesdites première et seconde séquences de décharge de batterie (10, 15).

**9.** Procédé selon la revendication 7 ou la revendication 8,

dans lequel le circuit de test de charge électrique est configuré pour provoquer, pendant ladite première séquence de décharge de batterie (10), un premier courant de décharge transitoire de batterie ($I_{trans\_1}$) qui est environ 10 à 100 % plus grand, spécifiquement environ 25 à 75 % plus grand, et plus spécifiquement environ 40 à 60 % plus grand que le premier courant de décharge continue de batterie ($I_{con\_1}$), et/ou

dans lequel le circuit de test de charge électrique est configuré pour provoquer, pendant ladite seconde séquence de décharge de batterie (15), un second courant de décharge transitoire de batterie ($I_{trans\_2}$) qui est environ 70 à 200 % plus grand, spécifiquement environ 80 à 160 % plus grand, et plus spécifiquement environ 90 à 120 % plus grand que le second courant de décharge continue de batterie ($I_{con\_2}$).

**10.** Procédé selon l'une quelconque des revendications précédentes 2 à 9, dans lequel une amplitude du premier courant de décharge continu ($I_{con\_1}$) est au moins 25 % plus grande, spécifiquement au moins 50 % plus grande, ou au moins 50A plus grande, spécifiquement au moins 100A plus grande que l'amplitude du second courant de décharge continu ($I_{con\_2}$).

**11.** Procédé selon l'une quelconque des revendications précédentes 2 à 10, dans lequel une différence d'amplitude entre le second courant de décharge transitoire de batterie ($I_{trans\_2}$) et le second courant de décharge continue de batterie ($I_{con\_2}$) est d'au moins 10 % plus grande, spécifiquement d'au moins 25 % plus grande, ou au moins 10A plus grande, en particulier au moins 25A plus grande que la différence d'amplitude entre le premier courant de décharge transitoire de batterie ($I_{trans\_1}$) et le premier courant de décharge continue de batterie ($I_{con\_1}$).

**12.** Procédé selon l'une quelconque des revendications précédentes, dans lequel une durée (11, 16) du courant de décharge continu (12, 17) de la première et/ou de la seconde séquence de décharge de batterie (10, 15) est d'au moins 10 secondes, spécifiquement au moins 30 secondes, et plus spécifiquement au moins 60 secondes, et dans lequel une durée de l'impulsion de courant de décharge transitoire (13, 18) de la première et/ou de la seconde séquence de décharge de batterie (10, 15) est inférieure à 5 secondes, spécifiquement moins de 3 secondes, et plus spécifiquement dans la plage de 0,1 à 2,0 ms.

**13.** Procédé de sélection d'un type et/ou d'une taille de batterie appropriée pour alimenter un circuit électrique de véhicule (1), le procédé comprenant :

la détermination d'un courant de charge continu maximum attendu ($I_{con\_new}$) et d'un courant de charge transitoire maximum attendu ($I_{trans\_new}$) du circuit électrique du véhicule (1),

l'identification d'une batterie (2) qui a une tension d'alimentation continue minimale ($U_{min\_con}$) et une tension d'alimentation transitoire minimale ($U_{min\_trans}$), lorsque la batterie (2) est connectée et fournit de l'énergie électrique audit circuit électrique du véhicule (1), qui sont supérieures audit courant de charge continu maximum attendu ($I_{con\_new}$) et audit courant de charge transitoire maximum attendu ($I_{trans\_new}$) du circuit électrique du véhicule (1), en utilisant le procédé selon l'une quelconque des revendications 1 à 12.

14. Procédé de fabrication d'un véhicule comprenant l'installation d'une batterie (2) dans le véhicule et la connexion de la batterie (2) à un circuit électrique du véhicule (1), dans lequel la batterie (2) a été sélectionnée en utilisant le procédé selon la revendication 13.

15. Système informatique comprenant un processeur configuré pour estimer une tension d'alimentation continue et transitoire minimale ($U_{min\_con}$, $U_{min\_trans}$) d'une batterie (2) lorsque la batterie (2) est connectée et fournit de l'énergie électrique à un circuit électrique de véhicule (1), le système informatique étant configuré pour :

la réception de paramètres de batterie caractérisant un profil de courant de décharge et un profil de tension de décharge de la batterie (2) enregistrés lors de l'exécution d'un premier test de charge électrique de la batterie (2) en réalisant une première séquence de décharge de batterie (10) comportant un courant de décharge continu (12) et au moins une impulsion de décharge transitoire (13),
la réception de paramètres de batterie caractérisant un profil de courant de décharge et un profil de tension de décharge de la batterie (2) enregistrés lors de l'exécution d'un second test de charge électrique de la batterie (2) en réalisant une seconde séquence de décharge de batterie (15) comportant un courant de décharge continu (17) et au moins une impulsion de décharge transitoire (18),
la détermination d'une valeur d'un coefficient de batterie continu reflétant un rapport entre la résistance interne de la batterie et le courant de décharge continu [$\Omega$/A] sur la base desdits paramètres reçus,
la détermination d'une valeur d'un coefficient de batterie transitoire reflétant un rapport entre la résistance interne de la batterie et le courant de décharge transitoire [$\Omega$/A] sur la base desdits paramètres reçus,
l'obtention d'informations concernant un courant de charge continu maximum attendu ($I_{con\_new}$) et un courant de charge transitoire maximum attendu ($I_{trans\_new}$) du circuit électrique du véhicule (1),
le calcul d'une estimation de la tension d'alimentation continue minimale ($U_{min\_con}$) à partir de la batterie (2) en utilisant ledit coefficient de batterie continu et ledit courant de charge continu maximum attendu ($I_{con\_new}$), et
le calcul d'une tension d'alimentation transitoire minimale ($U_{min\_trans}$) à partir de la batterie (2) en utilisant ledit coefficient de batterie transitoire et ledit courant de charge transitoire maximum attendu ($I_{trans\_new}$), lorsque la batterie (2) est connectée et fournit de l'énergie électrique audit circuit électrique du véhicule (1).

FIG.1

FIG.2

FIG.3

S10

↓

S20

↓

S30

↓

S40

↓

S50

↓

S60

FIG.4

S100

↓

S200

FIG.9

S1000

↓

S2000

FIG.10

10

Voltage [V]    $U_{OCV1}$    $U_{con\_1}$    $U_{trans\_1}$

13.5

13.0

12.5

12.0

11.5

11.0

10.5

10.0

FIG.5A

t [minutes]

19    20

11

11

Current [A]    $I_{con\_1}$    $I_{trans\_1}$    13    12

300

250

200

150

100

50

0

-50

t0    t1 t2    t3    t4    t5    t [minutes]

FIG.5B

FIG.6A

FIG.6B

FIG.7

FIG.8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002113593 A
- US 2011172939 A
- DE 102016121630
- US 2020331359 A
- US 6526361 B